# EUROPEAN PATENT SPECIFICATION

(11) **EP 3 845 607 B1**
(45) Date of publication and mention of the grant of the patent: **11.10.2023**
(21) Application number: 19855306.7
(22) Date of filing: 22.08.2019
(51) Int. Cl.: C09B 67/46, C09B 29/42, C09D 11/322, C09D 17/00, G02B 5/20, G03F 7/004, C09D 11/101, C09D 11/326, C09D 11/36, C09D 11/38, G02B 5/22, G03F 7/00, G03F 7/027, G03F 7/105

(54) **PIGMENT DISPERSION, RESIST COMPOSITION FOR COLOR FILTERS USING SAID PIGMENT DISPERSION, AND INK COMPOSITION**
PIGMENTDISPERSION, RESISTZUSAMMENSETZUNG FÜR FARBFILTER MIT DIESER PIGMENTDISPERSION UND TINTENZUSAMMENSETZUNG
DISPERSION DE PIGMENT, COMPOSITION DE RÉSERVE POUR FILTRES COLORÉS UTILISANT LADITE DISPERSION DE PIGMENT, ET COMPOSITION D'ENCRE

(30) Priority: 31.08.2018 JP 2018163972
(43) Date of publication of application: 07.07.2021
(73) Proprietor: CANON KABUSHIKI KAISHA, OHTA-KU Tokyo 146-8501 (JP)
(72) Inventor: SHINTOU, Taichi, Tokyo 146-8501 (JP); SHIROTA, Koromo, Tokyo 146-8501 (JP); HAYAKAWA, Ai, Tokyo 146-8501 (JP); SANTO, Tsuyoshi, Tokyo 146-8501 (JP)
(74) Representative: TBK
(86) International application number: PCT/JP2019/032897
(87) International publication number: WO 2020/045244

(56) References cited:
- JP-A- 2012 194 200
- JP-A- 2013 209 638
- JP-A- 2017 134 243
- JP-A- 2018 045 189
- US-A- 4 514 226
- US-A1- 2016 349 647

## Description

### [Technical Field]

The present invention relates to a pigment dispersion used in the production process of paints, inks, color filters and resin molded products. Furthermore, the present invention relates to a resist composition and an ink composition for a color filter using the pigment dispersion as a colorant.

### [Background Art]

A color filter is used for a color display using a liquid crystal. The color filter is indispensable for the color display of the liquid crystal display, and is an important component that affects the performance of the liquid crystal display. As a conventional method of producing a color filter, a dyeing method, a printing method, an inkjet method, and a photoresist method are known. Among these, the photoresist method has become the mainstream because it is easy to control the spectral characteristics and color reproducibility, and because the resolution is high and higher-definition patterning is possible.

In the production of color filters by the photoresist method, green pigments and yellow pigments have been used as colorants (Patent Literatures 1 and 2). However, color filters using pigments have problems such as a depolarization effect (depolarization of polarized light), a decrease in the contrast ratio of the color display of a liquid crystal display, and a decrease in the brightness of the color filter, as well as a problem of a decrease in dispersion stability with respect to organic solvents and polymers.

Therefore, attention has been paid to a production method using a dye as a colorant. For example, an example using a cyan pigment and a yellow azo dye (Patent Literature 2) and an example using a green pigment and a yellow azo dye (Patent Literature 3) have been reported. However, dyes have a problem in storage stability as compared with pigments. In addition, in order to obtain a color filter compatible with the next-generation ultra-high-definition displays such as 4K and 8K in recent years, it is insufficient to improve the dispersibility of the pigment for the reproducibility of the color space, and a pigment dispersion having excellent light transmission and color tone reproducibility is required.

### [Citation List]

### [Patent Literature]

PTL 1: Japanese Patent Application Laid-Open No. H11-14825
PTL 2: Japanese Patent No. 4481439
PTL 3: Japanese Patent Application Laid-Open No. 2010-139560

### [Summary of Invention]

### [Technical Problem]

In view of the above, an aspect of the present invention is to provide a pigment dispersion having excellent dispersibility and storage stability. In addition, another aspect of the present invention is to provide a resist composition and an ink composition for a color filter using the pigment dispersion.

### [Solution to Problem]

According to an aspect of the present invention, there is provided a pigment dispersion including: a dispersion medium, a compound represented by the following formula (1), and at least one pigment selected from the group consisting of C. I. Pigment Blue 15, C. I. Pigment Blue 15:1, C. I. Pigment Blue 15:2, C. I. Pigment Blue 15:3, C. I. Pigment Blue 15:4, and C. I. Pigment Blue 15:6, which are dispersed in the dispersion medium.

In addition, according to another aspect of the present invention, there are provided a green-toned resist composition and ink composition for a color filter using the pigment dispersion. 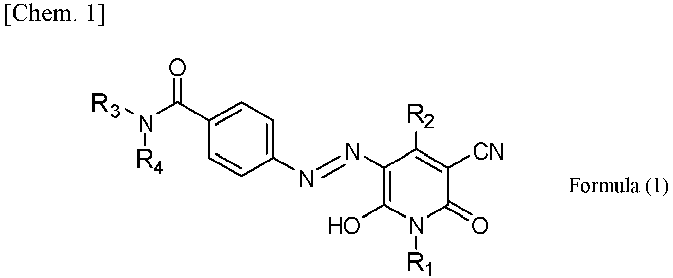 [In the formula (1), R₁ and R₂ each independently represent a linear or branched alkyl group having 1 to 4 carbon atoms, and R₃ and R₄ each independently represent a linear or branched alkyl group having 2 to 8 carbon atoms]

### [Advantageous Effects of Invention]

According to an aspect of the present invention, it is possible to provide a pigment dispersion having excellent dispersibility and storage stability.

In addition, according to another aspect of the present invention, it is possible to provide a green-toned resist composition and ink composition for a color filter using the pigment dispersion.

### [Brief Description of Drawings]

[Fig. 1]

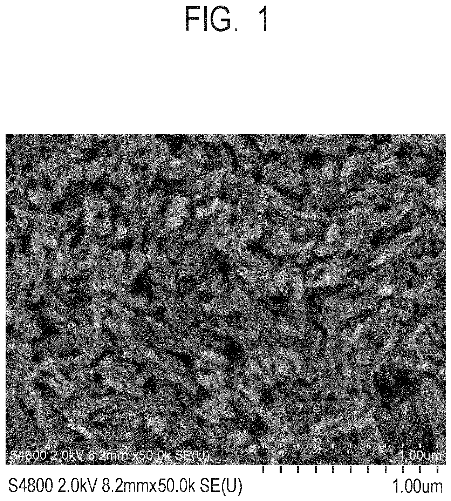

Fig. 1 is a diagram based on an SEM photograph in which a pigment dispersion (1) using a compound (1) represented by the formula (1) is observed at a magnification of 100,000 times.

### [Description of Embodiments]

Hereinafter, the present invention is described in more detail with reference to embodiments.

The present inventors have made earnest studies to solve the above-mentioned problems of the related art, and have found as a result that, by allowing a compound represented by the formula (1) to be present in a dispersion medium, it is possible to obtain a pigment dispersion having an excellent dispersibility of at least one pigment selected from the group consisting of C. I. Pigment Blue 15, C. I. Pigment Blue 15:1, C. I. Pigment Blue 15:2, C. I. Pigment Blue 15:3, and C. I. Pigment Blue 15:4.

In addition, the present inventors have found that, because of high brightness and excellent green hue, it is possible to obtain a resist composition and an ink composition for a green color filter capable of displaying an image having high spectral characteristics and display contrast. Thus, the present invention has been completed.

Examples of the cyan pigment used in the present invention include copper phthalocyanines such as C. I. Pigment Blue 15, 15:1, 15:2, 15:3, 15:4, and 15:6.

In the present invention, it is presumed that the interaction between the compound represented by the formula (1) and the above-mentioned pigment suppresses self-aggregation and enables fine dispersion. On the other hand, in the case of compounds other than the compound represented by the formula (1), aggregation is promoted by the interaction with the pigment by hydrogen bonding. 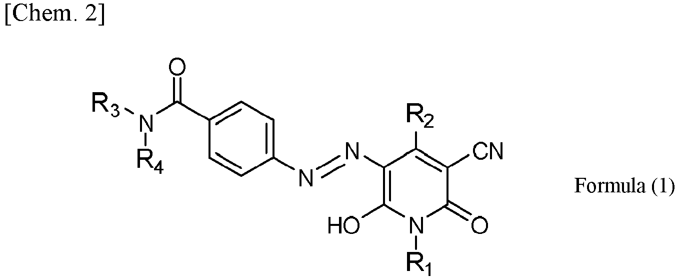 [In the formula (1), R₁ and R₂ each independently represent a linear or branched alkyl group having 1 to 4 carbon atoms, and R₃ and R₄ each independently represent a linear or branched alkyl group having 2 to 8 carbon atoms]

The linear or branched alkyl group having 1 to 4 carbon atoms in R₁ and R₂ in the formula (1) is not particularly limited, and examples thereof include a methyl group, an ethyl group, an n-propyl group, an iso-propyl group, an n-butyl group, a tert-butyl group, and a sec-butyl group.

In particular, since a pigment dispersion having excellent dispersibility can be obtained in the pigment of the present invention, R₁ is more preferably an ethyl group or propyl group, and R₂ is more preferably a methyl group.

The linear or branched alkyl group having 2 to 8 carbon atoms in R₃ and R₄ in the formula (1) is an ethyl group, an n-propyl group, an iso-propyl group, an n-butyl group, an octyl group, and a 2-ethylhexyl group, and more preferably a 2-ethylhexyl group particularly because a pigment dispersion having excellent dispersibility can be obtained in the pigment of the present invention.

The compound represented by the formula (1) according to the present invention can be synthesized with reference to, for example, a known method described in International Publication WO2008/114886.

Compounds (1) to (14) are presented as preferable specific examples of the compound represented by the formula (1) of the present invention, but the present invention is not limited to the following examples.

In addition, the compound represented by the formula (1) includes azohydrazo compatible isomers, and these compatible isomers are also within the scope of the present invention.

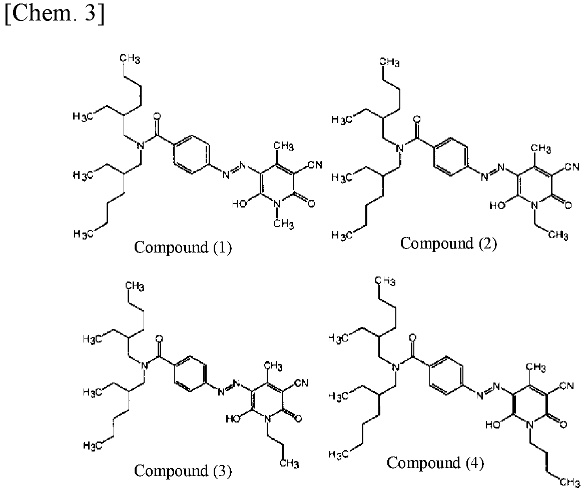

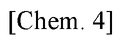

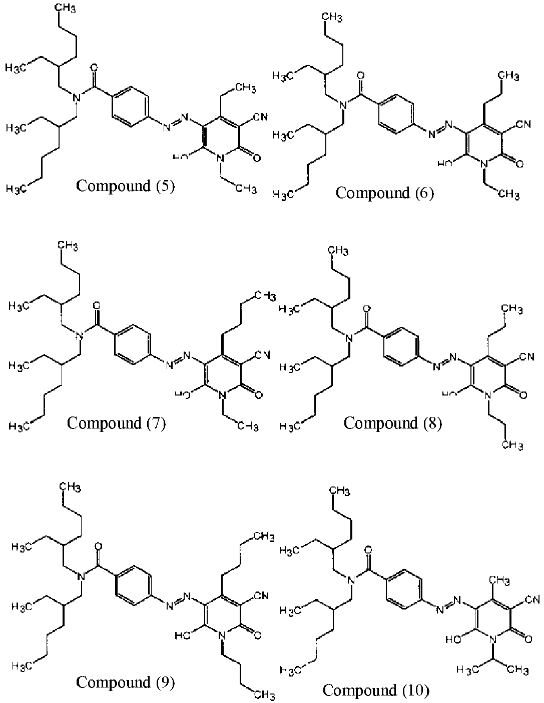

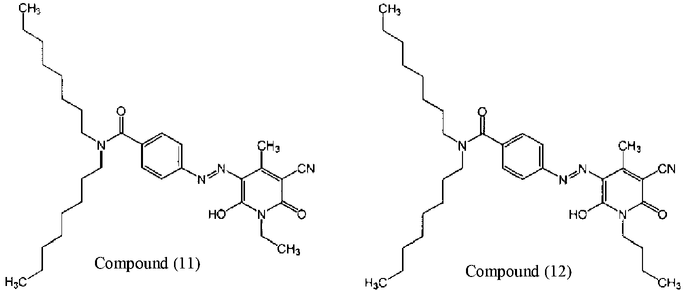

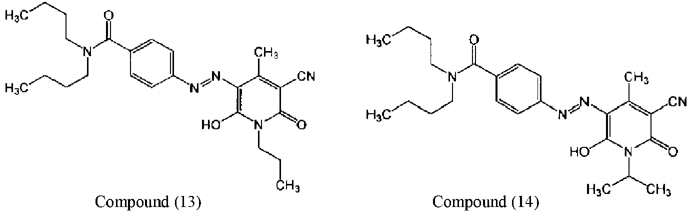

Among the above compounds, it is preferable to use the compounds (1), (2), (3), (4), (5), (9), (11), and (12), and it is more preferable to use the compounds (2) and (3).

The compound represented by the formula (1) has excellent coloring power. In addition, these compounds may be used alone or in combination with two or more known dyes may be used in order to adjust the color tone according to the purpose of use.

### <On Pigment Dispersion>

The pigment dispersion of the present invention can be obtained by dispersing the compound represented by the formula (1) and the following pigment in a dispersion medium.

The dispersion medium referred to in the present invention refers to water, an organic solvent, or a mixture thereof.

The following pigment means at least one pigment selected from the group consisting of
C. I. Pigment Blue 15, C. I. Pigment Blue 15:1, C. I. Pigment Blue 15:2, C. I. Pigment Blue 15:3, C. I. Pigment Blue 15:4, and C. I. Pigment Blue 15:6.

The pigment dispersion of the present invention can be dispersed by a known method. For example, it can be obtained as follows.

The pigment, the compound represented by the formula (1), and a resin if necessary, are dissolved in the dispersion medium and stirred. Furthermore, by applying a mechanical shearing force with a disperser, the pigment can be finely dispersed in the form of stable and uniform fine particles.

In addition, first, the resin is dissolved in the dispersion medium, then the pigment is suspended, and the compound represented by the formula (1) is gradually added while stirring to allow them to be sufficiently blended into the dispersion medium. Furthermore, by applying a mechanical shearing force with a disperser, it is possible to finely disperse the pigment in the form of stable and uniform fine particles.

The disperser used in the present invention is not particularly limited, but for example, a media type disperser such as a rotary shear type homogenizer, a ball mill, a sand mill, and an attritor, a high pressure opposed collision type disperser, are preferably used.

The content of the pigment in the pigment dispersion is preferably 1.0 to 30.0 parts by mass, more preferably 2.0 to 20.0 parts by mass, and further preferably 3.0 to 15.0 parts by mass, based on 100 parts by mass of the dispersion medium. If the pigment content is too low, the coloring power is low.

A content of the compound represented by the formula (1) is preferably 10 to 100 parts by mass, and more preferably 10 to 50 parts by mass, based on 100 parts by mass of the pigment.

When the content of the compound represented by the formula (1) is 10 parts by mass or more based on 100 parts by mass of the pigment, the dispersibility of the pigment can be improved. Also, the coloring power of the compound represented by the formula (1) is not insufficient.

When the content of the compound represented by the formula (1) is 100 parts by mass or less based on 100 parts by mass of the pigment, the dispersibility of the pigment can be improved.

The pigment dispersion of the present invention can be dispersed in water using an emulsifier in order to obtain good dispersion stability. The emulsifier is not particularly limited, and examples thereof include a cationic surfactant, an anionic surfactant, and a nonionic surfactant.

The cationic surfactant is not particularly limited, and examples thereof include the following. Dodecyl ammonium chloride, dodecyl ammonium bromide, dodecyl trimethyl ammonium bromide, dodecyl pyridinium chloride, dodecyl pyridinium bromide, and hexadecyl trimethyl ammonium bromide.

Examples of the anionic surfactant include fatty acid soaps such as sodium stearate and sodium dodecanoate, sodium dodecyl sulfate, sodium dodecylbenzene sulfate, and sodium lauryl sulfate.

The nonionic surfactant is not particularly limited, but examples thereof include the following. Dodecyl polyoxyethylene ether, hexadecyl polyoxyethylene ether, nonylphenyl polyoxyethylene ether, lauryl polyoxyethylene ether, sorbitan monooleate polyoxyethylene ether, and monodecanoyl sucrose.

The organic solvent that can be used as the dispersion medium of the pigment dispersion of the present invention is determined according to the intended use of the pigment and is not particularly limited. Specific examples include the following. Alcohols such as methyl alcohol, ethyl alcohol, modified ethyl alcohol, isopropyl alcohol, n-butyl alcohol, isobutyl alcohol, tert-butyl alcohol, sec-butyl alcohol, tert-amyl alcohol, 3-pentanol, octyl alcohol, benzyl alcohol, and cyclohexanol; glycols such as methyl cellosolve, ethyl cellosolve, diethylene glycol, and diethylene glycol monobutyl ether; ketones such as acetone, methyl ethyl ketone, and methyl isobutyl ketone; esters such as ethyl acetate, butyl acetate, ethyl propionate, and cellosolve acetate; hydrocarbon-based solvents such as hexane, octane, petroleum ether, cyclohexane, benzene, toluene, and xylene; halogenated hydrocarbon-based solvents such as carbon tetrachloride, trichloroethylene, and tetrabromoethane; ethers such as diethyl ether, dimethyl glycol, trioxane, and tetrahydrofuran; acetals such as methylal and diethyl acetal; organic acids such as formic acid, acetic acid, and propionic acid; and sulfur-nitrogen-containing organic compounds such as nitrobenzene, dimethylamine, monoethanolamine, pyridine, dimethyl sulfoxide, and dimethylformamide.

In addition, as the organic solvent used in the present invention, it is also possible to use an addition-polymerizable monomer or a condensation-polymerizable monomer. It is preferably an addition-polymerizable monomer. Specific examples include the following. Styrene-based monomers such as styrene, o-methylstyrene, m-methylstyrene, p-methylstyrene, o-ethylstyrene, methylstyrene, and p-ethylstyrene; acrylate-based monomers such as methyl acrylate, ethyl acrylate, propyl acrylate, butyl acrylate, octyl acrylate, dodecyl acrylate, stearyl acrylate, behenyl acrylate, 2-ethylhexyl acrylate, dimethylaminoethyl acrylate, diethylaminoethyl acrylate, acrylonitrile, and amide acrylate; methacrylate-based monomers such as methyl methacrylate, ethyl methacrylate, propyl methacrylate, butyl methacrylate, octyl methacrylate, dodecyl methacrylate, stearyl methacrylate, behenyl methacrylate, 2-ethylhexyl methacrylate, dimethylaminoethyl methacrylate, diethylaminoethyl methacrylate, methacrylonitrile, and amide methacrylate; olefin monomers such as ethylene, propylene, butylene, butadiene, isoprene, isobutylene, and cyclohexene; vinyl halides such as vinyl chloride, vinylidene chloride, vinyl bromide, and vinyl iodide; vinyl esters such as vinyl acetate, vinyl propionate, and vinyl benzoate; vinyl ethers such as vinyl methyl ether, vinyl ethyl ether, and vinyl isobutyl ether; and vinyl ketone compounds such as vinyl methyl ketone, vinyl hexyl ketone, and methyl isopropenyl ketone.

These can be used alone or in combination of two or more kinds depending on the intended use.

When the pigment dispersion of the present invention is used for a polymerized toner, among the above-mentioned polymerizable monomers, it is preferable to use styrene or a styrene-based monomer alone or in combination with another polymerizable monomer. Styrene is particularly preferable because of its ease of handling.

A resin may be further added to the pigment dispersion. The resin that can be used is determined according to the intended use and is not particularly limited. Specifically, for example, the following can be mentioned. Polystyrene, styrene copolymer, polyacrylic acid, polymethacrylic acid, polyacrylic acid ester, polymethacrylic acid ester, acrylic acid-based copolymer, methacrylic acid-based copolymer, polyester, polyvinyl ether, polyvinyl methyl ether, polyvinyl alcohol, and polyvinyl butyral. Other examples include polyurethane and polypeptides. These resins can be used alone or in combination of two or more kinds.

### <On Ink>

An ink composition can be prepared in which the pigment dispersion of the present invention can be used as an ink. A particularly preferable case is where the dispersion medium is an aqueous system. In addition, a mixed solvent of water and a water-soluble organic solvent may be used. The water-soluble organic solvent used here is not limited as long as it exhibits water solubility, and examples thereof include alcohols, polyhydric alcohols, polyethylene glycols, glycol ethers, nitrogen-containing polar solvents, and sulfur-containing polar solvents.

In the case of producing an ink containing the pigment dispersion of the present invention, the pH of the ink is not particularly limited, but in consideration of safety, one having a pH in the range of 4.0 to 11.0 is preferable. In addition, when producing an ink for an inkjet, a moisturizing solid content such as urea, a urea derivative, or trimethylolpropane may be used as a component of the ink in order to maintain the ink retention. The content of the moisturizing solid content in the ink, such as urea, a urea derivative, and trimethylolpropane, is generally preferably in the range of 0.1% by mass or more and 20.0% by mass or less, and more preferably in the range of 3.0% by mass or more and 10.0% by mass or less, based on the ink.

Moreover, in the case of producing ink, various additives such as pH adjusters, corrosion inhibitors, preservatives, fungicides, antioxidants, anti-reducing agents, evaporation accelerators, chelating agents, and water-soluble polymers may be contained in addition to the above-mentioned components, if necessary.

As described above, the ink containing the pigment dispersion of the present invention is particularly preferably used in an inkjet recording method in which the action of thermal energy causes droplets to be ejected for recording. Needless to say, the ink containing the pigment dispersion of the present invention can also be used as an ink applied to other inkjet recording methods and as a material for general writing instruments.

### <On Green Resist Composition for Color Filter>

The pigment dispersion of the present invention has a bright green color tone and can be used as a green color material, preferably a colorant for a color filter, due to its spectral characteristics.

The resist composition of the present invention contains at least one or more of binder resin, photopolymerizable monomer, photopolymerization initiator, solvent, and pigment dispersion of the present invention.

In addition, in a color filter in which two or more kinds of pixels with different spectral characteristics are arranged adjacent to each other on a substrate, the use of the pigment dispersion of the present invention for at least one of the multiple pixels (for example, red, green, and blue) makes it possible to obtain highly transparent and highly color-purity pixels.

The content of the pigment in the pigment dispersion of the present invention is preferably 0.1 to 400% by mass, and more preferably 1 to 200% by mass, based on the mass of the following binder resin.

The binder resin that can be used in the resist composition for a color filter of the present invention is not particularly limited, and may be any as long as the light irradiation part or the light shielding part can be dissolved by an organic solvent, an alkaline aqueous solution, water, or a commercially available developer. Further, from the viewpoint of workability and waste treatment, those having a composition capable of developing with water or alkali are more desirable.

As such a resin, a binder resin is generally known obtained by copolymerizing a hydrophilic monomer such as acrylic acid, methacrylic acid, 2-hydroxyethyl, acrylamide, N-vinylpyrrolidone, and a monomer having an ammonium salt, and a lipophilic monomer such as acrylic acid ester, methacrylic acid ester, vinyl acetate, styrene, and N-vinylcarbazole at an appropriate mixing ratio by a known method. These binder resins can be used in combination with a radically polymerizable monomer having an ethylenically unsaturated group, an oxirane ring, or a cationically polymerizable monomer having an oxetane ring, a radical generator, an acid generator, or a base generator. Then, they can be used as a negative type resist, that is, a type of resist in which the light shielding part is removed by development.

In addition, it is also possible to use a binder resin typified by tert-butyl carbonic acid ester, tert-butyl ester, tetrahydroxypyranyl ester, or tetrahydroxypyranyl ether of polyhydroxystyrene. This type of binder resin can be used as a positive type resist in combination with an acid generator, that is, a type of resist in which the light irradiation part is removed by development.

The resist composition for a color filter of the present invention may contain a photopolymerizable monomer having one or more ethylenically unsaturated double bonds as a monomer having an ethylenically unsaturated double bond that undergoes addition polymerization by irradiation with light. Examples of the photopolymerizable monomer include compounds having at least one addition polymerizable ethylenically unsaturated group in the molecule and having a boiling point of 100°C or higher at normal pressure. Examples can include monofunctional acrylates such as polyethylene glycol monoacrylate, polyethylene glycol monomethacrylate, polypropylene glycol monoacrylate, polypropylene glycol monomethacrylate, phenoxyethyl acrylate, and phenoxyethyl methacrylate, polyfunctional acrylates and methacrylates such as polyethylene glycol diacrylate, polyethylene glycol dimethacrylate, polypropylene glycol diacrylate, polypropylene glycol dimethacrylate, trimethylolethane triacrylate, trimethylolethane trimethacrylate, trimethylolpropane triacrylate, trimethylolpropane trimethacrylate, trimethylolpropane diacrylate, trimethylolpropane dimethacrylate, neopentyl glycol diacrylate, neopentyl glycol dimethacrylate, pentaerythritol tetraacrylate, pentaerythritol tetramethacrylate, pentaerythritol triacrylate, pentaerythritol trimethacrylate, dipentaerythritol hexaacrylate, dipentaerythritol hexamethacrylate, dipentaerythritol pentaacrylate, dipentaerythritol pentamethacrylate, hexanediol diacrylate, hexanediol dimethacrylate, trimethylolpropane tri(acryloyloxypropyl)ether, tri(acryloyloxyethyl)isocyanurate, tri(acryloyloxyethyl)cyanurate, glycerin triacrylate, and glycerin trimethacrylate, and polyfunctional acrylates and polyfunctional methacrylates formed by adding propylene oxide or ethylene oxide to a polyfunctional alcohol such as trimethylolpropane or glycerin and then acrylating or methacrylating it.

Furthermore, examples also include polyfunctional acrylates and methacrylates such as urethane acrylates, polyester acrylates, and epoxy acrylates which are reaction products of epoxy resin and acrylic acid or methacrylic acid. Preferable among the above are trimethylolpropane triacrylate, trimethylolpropane trimethacrylate, pentaerythritol tetraacrylate, pentaerythritol tetramethacrylate, dipentaerythritol hexaacrylate, dipentaerythritol hexamethacrylate, dipentaerythritol pentaacrylate, and dipentaerythritol pentamethacrylate.

The photopolymerizable monomer having two or more ethylenically unsaturated double bonds may be used alone or in combination of two or more kinds. The content of the polymerizable compound is generally 5 to 50% by mass, and particularly preferably 10 to 40% by mass, based on the mass (total solid content) of the colored photosensitive composition. When the content is 5% by mass or more, the required light sensitivity and pixel intensity can be obtained, and when the content is 50% by mass or less, the adhesiveness of the photosensitive resin layer does not become excessive.

When ultraviolet curable, the resist composition for a color filter of the present invention contains a photopolymerization initiator. Examples of the photopolymerization initiator include the following. Vicinal polyketaldonyl compounds, α-carbonyl compounds, acyloin ethers, diverse quinone compounds, triallyl imidazole dimer/p-aminophenyl ketone combinations, and trioxadiazole compounds. Preferable is 2-benzyl-2-dimethylamino-1-(4-morpholinophenyl)butanone (Irgacure 369: trade name, manufactured by Ciba Specialty Chemicals Inc.). Note that when an electron beam is used for forming pixels by the colored resist of the present invention, the above photopolymerization initiator is not essential.

The resist composition for a color filter of the present invention contains a solvent for dissolving or dispersing the binder resin, photopolymerizable monomer, photopolymerization initiator, and colorant. Examples of the solvent that can be used include the following. Cyclohexanone, ethyl cellosolve acetate, butyl cellosolve acetate, 1-methoxy-2-propyl acetate, diethylene glycol dimethyl ether, ethylbenzene, 1,2,4-trichlorobenzene, ethylene glycol diethyl ether, xylene, ethyl cellosolve, methyl-n-amyl ketone, propylene glycol monomethyl ether, toluene, methyl ethyl ketone, ethyl acetate, methanol, ethanol, isopropyl alcohol, butanol, isobutyl ketone, and petroleum solvents. These can be used alone or in combination.

As described above, the resist composition for a color filter of the present invention contains the pigment dispersion of the present invention as a colorant, and thus the hue of the formed pixels is good, and transparency and translucency can be improved.

### [Examples]

Hereinafter, the present invention is described in more detail with reference to Examples and Comparative Examples, but the present invention is not limited to these Examples. In the following, "part" means "part by mass".

The compounds presented in Table 1 and represented by the formula (1) of the present invention were produced by the methods described below. Production examples are shown with compound (2) as a representative, but the present invention is not limited thereto.

### <Production Example 1: Production of Compound (2)>

Under a nitrogen atmosphere, 29 parts of thionyl chloride was added dropwise to 100 parts of chloroform in 10 parts of o-nitrobenzoic acid, and the mixture was further reacted at 60°C for 1 hour. After completion of the reaction, the mixture was cooled to 10°C or lower, and 9 parts of triethylamine and 15 parts of di(2-ethylhexyl)amine were sequentially added dropwise. Further, the mixture was stirred at 80°C for 2 hours, and after completion of the reaction, the mixture was extracted with chloroform. By concentrating under reduced pressure, 18 parts of intermediate (A) was obtained.

To 10 parts of the above intermediate (A), 50 parts of ethanol and 18 parts of a 20% sodium sulfide aqueous solution were added and reacted at 75°C for 1 hour. After completion of the reaction, the mixture was extracted with chloroform and the solution was concentrated under reduced pressure to obtain 7.4 parts of intermediate (B).

To 5.9 parts of the above intermediate (B), 3.4 parts of concentrated hydrochloric acid and 59 parts of methanol were added and cooled to 10°C or lower. To this solution, a solution of 1.4 parts of sodium nitrite in water (2.0 parts) was slowly added dropwise so as not to exceed 10°C, and the mixture was reacted for another 1 hour. Then, 0.5 parts of sulfamic acid were added and stirred for 20 minutes to obtain a diazonium salt solution.

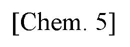

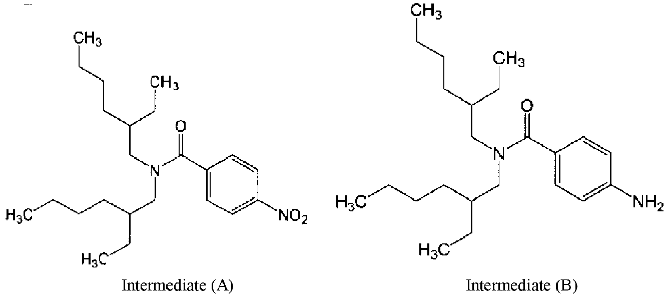

Next, a solution of 2.7 parts of 3-cyano-4-methyl-6-oxo-2-pyridone in 25 parts of N,N-dimethylformamide and 20 parts of methanol was cooled to 10°C or lower, and the diazonium salt solution was added dropwise so as to maintain the temperature at 10°C or lower. A saturated aqueous sodium carbonate solution was added to adjust the pH to 5 to 6, and the reaction was carried out at 10°C or lower for 2 hours. After completion of the reaction, the solvent was evaporated under reduced pressure and purified by column chromatography to obtain 5.2 parts of compound (2).

The obtained compound was identified using the following analyzer and spectrometer.
· ¹H nuclear magnetic resonance spectroscopy (1H-NMR) device (AVANCE-600 NMR Spectrometer, manufactured by BRUKER)
· High performance liquid chromatography mass spectrometer (LCMS-2010, manufactured by Shimadzu Corporation)

### [Production of Pigment Dispersion]

The pigment dispersions of the present invention and comparative pigment dispersions were produced by the methods described below.

### <Example 1>

The following materials were mixed and dispersed by an attritor (manufactured by NIPPON COKE & ENGINEERING. CO., LTD.) for 1 hour to obtain the pigment dispersion (1) of the present invention. An SEM photograph of the pigment dispersion (1) is shown in Fig. 1.

| | |
|---|---|
| · C. I. Pigment Blue 15:3 (manufactured by Sanyo Color Works, Ltd., trade name "CYANE BLUE 3023 ") | 5 parts |
| · Compound (1) | 3.0 parts |
| · Cyclohexanone | 120 parts |

### <Preparation of Green Resist Composition>

| | |
|---|---|
| · Acrylic copolymer composition composed of 40% by mass of n-butyl methacrylate, 30% by mass of acrylic acid, and 30% by mass of hydroxyethyl methacrylate (weight average molecular weight 10,000) | 6.7 parts |
| · Dipentaerythritol pentaacrylate | 1.3 parts |
| · 2-Benzyl-2-dimethylamino-1-(4-morpholinophenyl)-butanone (photopolymerization initiator) | 0.4 parts |
| · Cyclohexanone | 96 parts |

To the above solution, 22 parts of the pigment dispersion (1) was slowly added, and the mixture was stirred at room temperature for 3 hours. This was filtered through a 1.5 µm filter to obtain a green resist composition (1) for a color filter.

The green resist composition (1) for a color filter was applied onto a glass substrate for a color filter with a spin coater, and then dried at 90°C for 3 minutes to obtain a green coating film. Further, each coating film was entirely exposed to ultraviolet rays of 100 mJ/cm² through a photomask using a high-pressure mercury lamp, and post-cured at 180°C to prepare a color filter (1).

### <Examples 2 to 10 and 29 to 33 and Reference Examples 11 to 28>

Pigment dispersions (2) to (33) were obtained in the same manner as in Example 1 except for using the pigments and compounds (2) to (5), (9), (11), and (12) presented in Table 1 instead of using C. I. Pigment Blue 15:3 and compound (1) in Example 1. In addition, in the same manner, green resist compositions (2) to (33) for color filters and corresponding color filters (2) to (33) were obtained.

### <Comparative Examples 1 to 30>

Comparative pigment dispersions (1) to (35) were obtained in the same manner as in Example 1 except for using the pigments and comparative compounds (1) to (4) presented in Table 1 instead of using C. I. Pigment Blue 15:3 and compound (1) in Example 1. In addition, in the same manner, green resist compositions (1) to (35) for color filters and corresponding color filters (1) to (35) were obtained.

The comparative compounds are presented below.

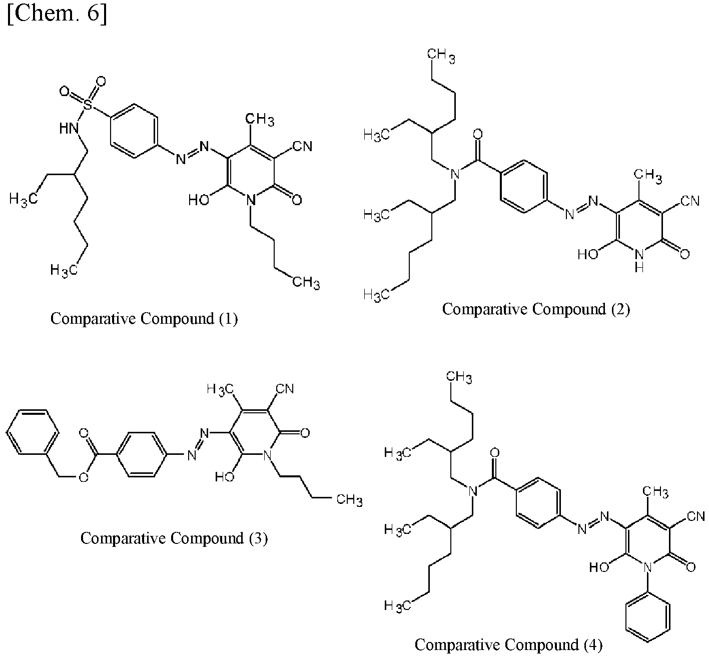

### <Evaluation>

### [Dispersibility]

The dispersibility of the pigment dispersions was evaluated as follows. It was determined by measuring the particle size of the pigments using a particle size measuring device (Grind Meter, Tester Sangyo Co., Ltd.).
A: Less than 2.5 µm (very good dispersibility)
B: 2.5 µm or more and less than 4.5 µm (good dispersibility)
C: 4.5 µm or more (poor dispersibility)

### [Storage Stability]

The above-obtained pigment dispersion in an amount of 20 mL was added to a 50 mL sample bottle, sealed, and allowed to stand for 48 hours under room temperature (25°C) conditions to evaluate the storage stability of the pigment dispersion. Similarly, 20 mL of the green resist composition for a color filter obtained above was added to a 50 mL sample bottle, sealed, and allowed to stand for 48 hours under room temperature (25°C) conditions to evaluate the storage stability of the resist composition. The presence or absence of aggregates in each of the pigment dispersions and the resist compositions was visually observed with a phase-contrast microscope (BX53, manufactured by Olympus Corporation). It was determined that the smaller in amount the aggregates, the better the storage stability.

Criteria for storage stability evaluation of pigment dispersions and green resist compositions for color filters
A: Good without aggregates.
B: With a small amount of aggregates generated.
C: With aggregates generated.

**[Table 1]**

| | Pigment | General Formula (1) | Pigment dispersion | Dispersibility Evaluation | Particle Diameter (µm) | Storage Stability Evaluation | Resist composition | Storage Stability Evaluation |
|---|---|---|---|---|---|---|---|---|
| Example 1 | P.B.15:3 | Compound (1) | (1) | A | 1.8 | A | (1) | A |
| Example 2 | P.B.15:1 | Compound (2) | (2) | A | 2.3 | A | (2) | A |
| Example 3 | P.B.15:3 | Compound (2) | (3) | A | 2.4 | A | (3) | A |
| Example 4 | P.B.15:4 | Compound (2) | (4) | A | 2.0 | A | (4) | A |
| Example 5 | P.B.15:6 | Compound (2) | (5) | A | 2.1 | A | (5) | A |
| Example 6 | P.B.15:3 | Compound (3) | (6) | A | 2.3 | A | (6) | A |
| Example 7 | P.B.15:3 | Compound (4) | (7) | A | 2.3 | A | (7) | A |
| Example 8 | P.B.15:3 | Compound (5) | (8) | A | 2.3 | A | (8) | A |
| Example 9 | P.B.15:3 | Compound (9) | (9) | A | 2.0 | A | (9) | A |
| Example 10 | P.B.15:3 | Compound (5) | (10) | A | 2.3 | A | (10) | A |
| Example 11^{∗} | P.G.7 | Compound (2) | (11) | A | 2.3 | A | (11) | A |
| Example 12^{∗} | P.G.7 | Compound (3) | (12) | A | 1.6 | A | (12) | A |
| Example 13^{∗} | P.G.7 | Compound (4) | (13) | A | 1.8 | A | (13) | A |
| Example 14^{∗} | P.G.7 | Compound (5) | (14) | A | 2.0 | A | (14) | A |
| Example 15^{∗} | P.G.7 | Compound (9) | (15) | A | 1.9 | A | (15) | A |
| Example 16^{∗} | P.G.36 | Compound (2) | (16) | A | 2.0 | A | (16) | A |
| Example 17^{∗} | P.G.36 | Compound (3) | (17) | A | 2.1 | A | (17) | A |
| Example 18^{∗} | P.G.36 | Compound (4) | (18) | A | 2.1 | A | (18) | A |
| Example 19^{∗} | P.G.36 | Compound (5) | (19) | A | 2.1 | A | (19) | A |
| Example 20^{∗} | P.G.36 | Compound (9) | (20) | A | 2.3 | A | (20) | A |
| Example 21^{∗} | P.G.58 | Compound (1) | (21) | A | 2.3 | A | (21) | A |
| Example 22^{∗} | P.G.58 | Compound (2) | (22) | A | 1.6 | A | (22) | A |
| Example 23^{∗} | P.G.58 | Compound (3) | (23) | A | 1.6 | A | (23) | A |
| Example 24^{∗} | P.G.58 | Compound (4) | (24) | A | 1.8 | A | (24) | A |
| Example 25^{∗} | P.G.58 | Compound (5) | (25) | A | 2.0 | A | (25) | A |
| Example 26^{∗} | P.G.58 | Compound (9) | (26) | A | 2.0 | A | (26) | A |
| Example 27^{∗} | P.G.58 | Compound (11) | (27) | A | 2.1 | A | (27) | A |
| Example 28^{∗} | P.G.58 | Compound (12) | (28) | A | 2.0 | A | (28) | A |
| Example 29 | P.B.15:6 | Compound (3) | (29) | A | 2.1 | A | (29) | A |
| Example 30 | P.B.15:6 | Compound (4) | (30) | A | 2.3 | A | (30) | A |
| Example 31 | P.B.15:6 | Compound (9) | (31) | A | 2.2 | A | (31) | A |
| Example 32 | P.B.15:6 | Compound (11) | (32) | A | 2.3 | A | (32) | A |
| Example 33 | P.B.15:6 | Compound (12) | (33) | A | 2.4 | A | (33) | A |
| Comparative Example 1 | P.B.15:1 | None | Comp. (1) | C | 4.5 | C | Comp. (1) | C |
| Comparative Example 2 | P.B.15:1 | Comparative Compound (1) | Comp. (2) | B | 2.8 | C | Comp. (2) | C |
| Comparative Example 3 | P.B.15:1 | Comparative Compound (2) | Comp. (3) | C | 4.5 | C | Comp. (3) | C |
| Comparative Example 4 | P.B.15:1 | Comparative Compound (3) | Comp. (4) | B | 2.8 | C | Comp. (4) | C |
| Comparative Example 5 | P.B.15:1 | Comparative Compound (4) | Comp. (5) | C | 4.5 | C | Comp. (5) | C |
| Comparative Example 6 | P.B.15:3 | None | Comp. (6) | C | 4.5 | C | Comp. (6) | C |
| Comparative Example 7 | P.B.15:3 | Comparative Compound (1) | Comp. (7) | B | 3.0 | C | Comp. (7) | C |
| Comparative Example 8 | P.B.15:3 | Comparative Compound (2) | Comp. (8) | C | 4.5 | C | Comp. (8) | C |
| Comparative Example 9 | P.B.15:3 | Comparative Compound (3) | Comp. (9) | B | 3.2 | C | Comp. (9) | C |
| Comparative Example 10 | P.B.15:3 | Comparative Compound (4) | Comp. (10) | C | 4.5 | C | Comp. (10) | C |
| Comparative Example 11 | P.B.15:4 | None | Comp. (11) | C | 4.8 | C | Comp. (11) | C |
| Comparative Example 12 | P.B.15:4 | Comparative Compound (1) | Comp. (12) | B | 3.0 | C | Comp. (12) | C |
| Comparative Example 13 | P.B.15:4 | Comparative Compound (2) | Comp. (13) | C | 4.6 | C | Comp. (13) | C |
| Comparative Example 14 | P.B.15:4 | Comparative Compound (3) | Comp. (14) | B | 2.8 | C | Comp. (14) | C |
| Comparative Example 15 | P.B.15:4 | Comparative Compound (4) | Comp. (15) | C | 4.6 | C | Comp. (15) | C |
| Comparative Example 16 | P.B.15:6 | None | Comp. (16) | C | 4.9 | C | Comp. (16) | C |
| Comparative Example 17 | P.B.15:6 | Comparative Compound (1) | Comp. (17) | B | 3.2 | C | Comp. (17) | C |
| Comparative Example 18 | P.B.15:6 | Comparative Compound (2) | Comp. (18) | C | 4.8 | C | Comp. (18) | C |
| Comparative Example 19 | P.B.15:6 | Comparative Compound (3) | Comp. (19) | B | 2.9 | C | Comp. (19) | C |
| Comparative Example 20 | P.B.15:6 | Comparative Compound (4) | Comp. (20) | C | 5.0 | C | Comp. (20) | C |
| Comparative Example 21 | P.G.7 | None | Comp. (21) | C | 4.6 | C | Comp. (21) | C |
| Comparative Example 22 | P.G.7 | Comparative Compound (1) | Comp. (22) | B | 3.2 | C | Comp. (22) | C |
| Comparative Example 23 | P.G.7 | Comparative Compound (2) | Comp. (23) | C | 4.5 | C | Comp. (23) | C |
| Comparative Example 24 | P.G.7 | Comparative Compound (3) | Comp. (24) | B | 3.4 | C | Comp. (24) | C |
| Comparative Example 25 | P.G.7 | Comparative Compound (4) | Comp. (25) | C | 4.6 | C | Comp. (25) | C |
| Comparative Example 26 | P.G.36 | None | Comp. (26) | C | 4.7 | C | Comp. (26) | C |
| Comparative Example 27 | P.G.36 | Comparative Compound (1) | Comp. (27) | B | 3.0 | C | Comp. (27) | C |
| Comparative Example 28 | P.G.36 | Comparative Compound (2) | Comp. (28) | C | 4.6 | C | Comp. (28) | C |
| Comparative Example 29 | P.G.36 | Comparative Compound (3) | Comp. (29) | B | 3.6 | C | Comp. (29) | C |
| Comparative Example 30 | P.G.36 | Comparative Compound (4) | Comp. (30) | C | 4.5 | C | Comp. (30) | C |
| Comparative Example 31 | P.G.58 | None | Comp. (31) | C | 4.8 | C | Comp. (31) | C |
| Comparative Example 32 | P.G.58 | Comparative Compound (1) | Comp. (32) | B | 3.1 | C | Comp. (32) | C |
| Comparative Example 33 | P.G.58 | Comparative Compound (2) | Comp. (33) | C | 4.6 | C | Comp. (33) | C |
| Comparative Example 34 | P.G.58 | Comparative Compound (3) | Comp. (34) | B | 3.5 | C | Comp. (34) | C |
| Comparative Example 35 | P.G.58 | Comparative Compound (4) | Comp. (35) | C | 4.7 | C | Comp. (35) | C |

| | | | | | | | | |
|---|---|---|---|---|---|---|---|---|
| ^{∗} Reference Example | | | | | | | | |

As presented in Table 1, the pigment dispersions of the present invention have excellent dispersibility and storage stability as compared with Comparative Examples. It was also confirmed that the resist compositions for color filters using the same were also excellent in storage stability. In addition, the color filters produced by using the above-mentioned green resist compositions for color filters had good light transmission and color tone.

### [Industrial Applicability]

According to the present invention, it is possible to provide a pigment dispersion containing at least one pigment selected from the group consisting of C. I. Pigment Blue 15, C. I. Pigment Blue 15:1, C. I. Pigment Blue 15:2, C. I. Pigment Blue 15:3, C. I. Pigment Blue 15:4, and C. I. Pigment Blue 15:6 and having excellent dispersibility and storage stability. Furthermore, the use of the pigment dispersion makes it possible to provide a good green-toned resist composition and ink composition for a color filter.

## Claims

1. A pigment dispersion comprising: a dispersion medium, a compound represented by the following formula (1), and at least one pigment selected from the group consisting of C. I. Pigment Blue 15, C. I. Pigment Blue 15:1, C. I. Pigment Blue 15:2, C. I. Pigment Blue 15:3, C. I. Pigment Blue 15:4, and C. I. Pigment Blue 15:6, which are dispersed in the dispersion medium. 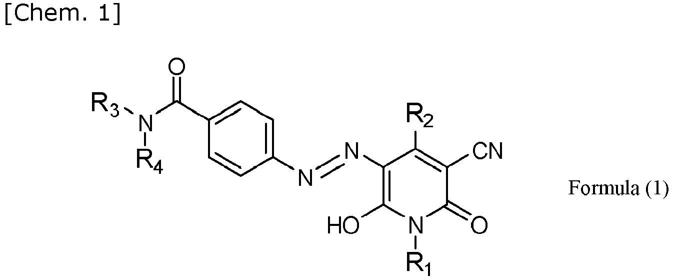 [In the formula (1), R₁ and R₂ each independently represent a linear or branched alkyl group having 1 to 4 carbon atoms, and R₃ and R₄ each independently represent a linear or branched alkyl group having 2 to 8 carbon atoms]

2. The pigment dispersion according to claim 1, wherein the pigment is C. I. Pigment Blue 15:6.

3. The pigment dispersion according to claim 1 or 2, wherein a content of the compound represented by the formula (1) is 10 to 100 parts by mass based on 100 parts by mass of the pigment.

4. An ink composition comprising: at least one pigment dispersion according to any one of claims 1 to 3.

5. A resist composition for a color filter, comprising: at least one pigment dispersion according to any one of claims 1 to 3.

## Patentansprüche

1. Pigmentdispersion, umfassend: ein Dispersionsmedium, eine durch die folgende Formel (1) dargestellte Verbindung, und zumindest ein Pigment, ausgewählt aus der Gruppe, bestehend aus C. I. Pigment Blue 15, C. I. Pigment Blue 15:1, C. I. Pigment Blue 15:2, C. I. Pigment Blue 15:3, C. I. Pigment Blue 15:4 und C. I. Pigment Blue 15:6, die in dem Dispersionsmedium dispergiert sind. 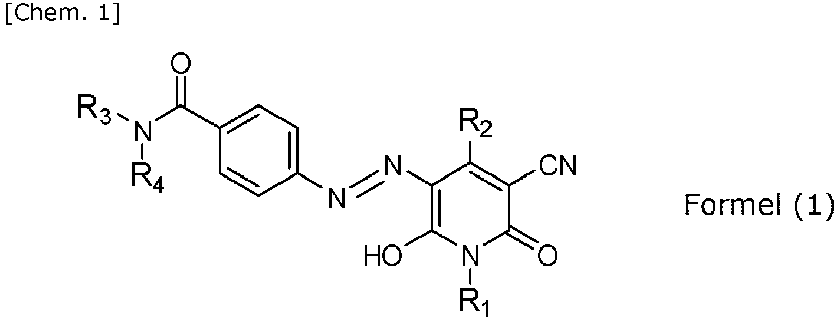 [In der Formel (1) stellen R₁ und R₂ jeweils unabhängig eine lineare oder verzweigte Alkylgruppe mit 1 bis 4 Kohlenstoffatomen dar, und R₃ und R₄ stellen jeweils unabhängig eine lineare oder verzweigte Alkylgruppe mit 2 bis 8 Kohlenstoffatomen dar]

2. Pigmentdispersion nach Anspruch 1, wobei das Pigment C.I. Pigment Blue 15:6 ist.

3. Pigmentdispersion nach Anspruch 1 oder 2, wobei der Gehalt an der durch die Formel (1) dargestellten Verbindung 10 bis 100 Massenteile, bezogen auf 100 Massenteile des Pigments, beträgt.

4. Tintenzusammensetzung, die umfasst: zumindest eine Pigmentdispersion nach einem der Ansprüche 1 bis 3.

5. Resistzusammensetzung für einen Farbfilter, die enthält: zumindest eine Pigmentdispersion nach einem der Ansprüche 1 bis 3.

## Revendications

1. Dispersion de pigment, comprenant : un milieu de dispersion, un composé représenté par la formule (1) suivante, et au moins un pigment choisi dans le groupe constitué de pigment bleu de C. I. 15, de pigment bleu de C. I. 15:1, de pigment bleu de C. I. 15:2, de pigment bleu de C. I. 15:3, de pigment bleu de C. I. 15:4 et de pigment bleu de C. I. 15:6, qui sont dispersés dans le milieu de dispersion ; 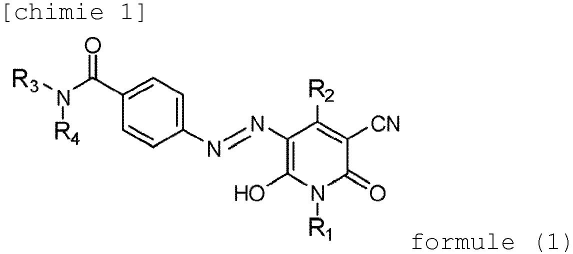 [dans la formule (1), R₁ et R₂ représentent chacun indépendamment un groupe alkyle linéaire ou ramifié comportant de 1 à 4 atomes de carbone, et R₃ et R₄ représentent chacun indépendamment un groupe alkyle linéaire ou ramifié comportant de 2 à 8 atomes de carbone].

2. Dispersion de pigment selon la revendication 1, dans laquelle le pigment est un pigment bleu de C. I. 15:6.

3. Dispersion de pigment selon la revendication 1 ou 2, dans laquelle une teneur en le composé représenté par la formule (1) s'inscrit dans la plage de 10 à 100 parties par masse sur la base de 100 parties par masse du pigment.

4. Composition d'encre, comprenant : au moins une dispersion de pigment selon l'une quelconque des revendications 1 à 3.

5. Composition d'agent de réserve pour un filtre coloré, comprenant : au moins une dispersion de pigment selon l'une quelconque des revendications 1 à 3.
